(19) Europäisches Patentamt
European Patent Office
Office européen des brevets

(11) **EP 3 258 317 B1**

(12) **EUROPEAN PATENT SPECIFICATION**

(45) Date of publication and mention
of the grant of the patent:
**19.01.2022 Bulletin 2022/03**

(21) Application number: **16174808.2**

(22) Date of filing: **16.06.2016**

(51) International Patent Classification (IPC):
*G03F 7/00* *(2006.01)*    *G03F 7/075* *(2006.01)*
*G03F 7/09* *(2006.01)*

(52) Cooperative Patent Classification (CPC):
**G03F 7/091; G03F 7/0002; G03F 7/0752;
G03F 7/094**

(54) **METHOD FOR PERFORMING EXTREME ULTRA VIOLET (EUV) LITHOGRAPHY**

VERFAHREN ZUR DURCHFÜHRUNG VON EXTREM-ULTRAVIOLETTER (EUV)-LITHOGRAFIE

PROCÉDÉ PERMETTANT D'EFFECTUER UNE LITHOGRAPHIE DE LUMIÈRE ULTRAVIOLETTE
EXTRÊME (EUV)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**20.12.2017 Bulletin 2017/51**

(73) Proprietors:
• **IMEC VZW**
**3001 Leuven (BE)**
• **Katholieke Universiteit Leuven**
**3000 Leuven (BE)**

(72) Inventors:
• **De Simone, Danilo**
**3001 Leuven (BE)**
• **Vesters, Yannick Pierre Vincent**
**3001 Leuven (BE)**
• **Gronheid, Roel**
**3001 Leuven (BE)**

(74) Representative: **Patent Department IMEC**
**IMEC vzw**
**Patent Department**
**Kapeldreef 75**
**3001 Leuven (BE)**

(56) References cited:
**US-A1- 2004 214 113    US-A1- 2009 269 678
US-A1- 2014 239 462    US-B1- 6 830 850**

## Description

## Technical field of the disclosure

The present disclosure is related to the field of extreme ultraviolet lithography (EUVL). More specifically, the present disclosure relates to a method and an intermediate structure for performing EUVL with increased resist sensitivity.

## Background of the disclosure

Extreme Ultraviolet Lithography (EUVL) is targeted to be choice of lithographic patterning technique in the manufacture of ultra large scale integration systems (ULSI) in semiconductor industry, which manufacturing is driven by the motivation of keeping up with Moore's Law. Due to feature size shrinkage following this motivation, photoresist films must be made thinner to keep a reasonable aspect ratio and avoid pattern collapse. However, due to the small thickness of EUV resist, which may typically be in the range of 10 nm to 60 nm, only a small portion, typically about 10-30%, of the EUV radiation that impinges on the wafer is absorbed by the photoresist layer. The remainder of the light passes through the photoresist layer and is absorbed in the substrate. This raises an issue for the performance of the EUV Lithography and presents itself as a challenge to be overcome for a successful integration of EUVL. In this respect, enhancement of EUV photoresist sensitivity becomes an important criteria in order to improve the performance of the EUV lithography.

Underlayer materials applied under the EUV photoresist have been proposed for the purpose of promoting adhesion as well as reducing pattern collapse. Furthermore, underlayer materials are used to enhance EUV photosensitivity of resist, however none of these layers has been shown to work experimentally so far. The use of an underlayer mainly relies on redirecting the energy from the EUV photons back to the EUV photoresist in the form of photons, secondary electrons or photo-acid-generators (PAGs) has been referred to in the work of H. Xu et.al. Proceedings of SPIE V. 7273, 2009. The work J.S. Kim et. al, J. Vac. Sci. Technol. B (33)6, 2015 *presents simulation results with respect to the use of an underlayer with lower refractive indexes under the photoresist layer leading to increased reflection at the photoresist/underlayer interface that resulted in an increased number of photons in the photoresist layer. They conclude that the difference in refractive index between the underlayer and the photoresist should be maintained below 5% in order to optimize photoresist imaging performance for both the dense and isolated patterns.*

The likelihood of success with redirecting the energy from the EUV photons back to the EUV photoresist in the form of secondary electrons is questionable since the thermalization distance of these electrons, which is typically 1nm to 3nm, is very short compared to the photoresist film thickness, which is typically in the range of 10 nm to 60nm.

While the use of PAGs, on the other hand, can result in keeping the photoresist profile straight by reducing footing and scumming, uncontrolled photo-acid diffusion can still result in RLS trade-off by compromising LER and resolution as disclosed in the work of H. Xu et. al., Proc. Of SPIE Vol. 7273, 2009.

US 2004/0214113 A1 relates to active hardmask for lithographic patterning. In an implementation, energy reaching the lower surface of a photoresist may be redirected back into the photoresist material. This may be done by, for example, reflecting and/or fluorescing the energy from a hardmask provided on the wafer surface back into the photoresist.

US 2009/0269678 A1 relates to photolithography, and notably to photolithography at short wavelengths. It relates more precisely to a lithography mask structure intended for use in reflection and to a process for fabricating this mask structure.

Therefore, there is still a need in the art for methods and structures that can improve EUV lithography performance and can provide EUV photoresist sensitivity enhancement without jeopardizing lithographic performance indicators such as, for example, line edge roughness (LER), line width roughness (LWR) and resolution and without imposing limitative remedies.

## Summary of the Disclosure

The present invention provides a method and an intermediate structure as defined in claims 1 and 8 for increasing the performance of the EUV lithography.

It is an object of the present disclosure to provide a method and an intermediate structure as defined in claims 1 and 8 for performing EUV lithographic processing with increased photon absorption in the EUV photoresist layer, thereby increasing EUV photoresist layer sensitivity.

It is an advantage of the present disclosure that an enhancement in EUV photoresist sensitivity may be provided by using a multi-layer stack since reflected EUV photons will go back into the EUV photoresist layer, thus increasing photon absorption in the EUV photoresist layer.

The multi-layer stack of the present invention is a self-organized di-block copolymer.

It is, therefore, an advantage of the present disclosure that enhancement in EUV photoresist sensitivity leads to reduce the dose applied at the scanner level, compared to state of the art, during the EUV lithographic processing.

It is an advantage of the present disclosure that reduction of dose at the scanner level, in turn, increases the throughput of the EUV lithographic processing.

It is an advantage of the present disclosure that line width roughness (LWR)of patterned structures in the underlying substrate may be reduced.

It is an advantage of the present disclosure that the multi-layer stack may be a Bragg reflector.

It is an advantage of the present disclosure that the multi-layer stack is suitable for use as an etch mask to pattern the underlying substrate. In this way, the multi-layer stack may act as a hard mask layer as well as a layer for enhancing EUV photoresist sensitivity.

The above objective is accomplished by a method and an intermediate structure according to claims 1 and 8.

In a first aspect, the present disclosure relates to a method for performing an extreme ultraviolet (EUV) lithographic processing. The method comprises obtaining a substrate to be patterned. This substrate has an upper main surface. An EUV photoresist layer is provided on the upper main surface and at least one opening is formed in the EUV photoresist layer. The method further comprises providing a multi-layer stack that is sandwiched between the EUV photoresist layer and the upper main surface of the substrate. The multi-layer stack is a self-organized di-block copolymer, and has an upper surface and consists of a first layer of a first material and a second layer of a second material. The first material and the second material have different refractive indexes and the first layer and the second layer are stacked alternatingly and repeatedly on one another. The at least one opening exposes a part of the upper main surface of the multilayer stack.

The disclosure originates from the realization by the inventors that the presence of a multi-layer stack, which is present in contact with and in between the EUV photoresist layer and the substrate, leads to the occurrence of more reflections of EUV light from each of the interfaces between the layers of the multi-layer stack that enter back into the EUV photoresist layer.

The present disclosure takes advantage of redirecting the EUV photons back to the EUV photoresist layer in order to enhance EUV photoresist sensitivity. In this way, the dose at the scanner level may also be reduced since the dose felt by the EUV photoresist layer will be higher than the dose set at the scanner level thanks to the presence of the multi-layer stack under the EUV photoresist layer.

Reducing the dose at the scanner level is advantageous because it will lead to an increase in the throughput, where currently low throughput is one of the major drawbacks of the EUV photolithographic processing. Since the absorbed photons in the EUV photoresist layer will be higher, the photon shot noise in the EUV photoresist layer will be reduced for the value of dose set at the scanner level. Consequently, LWR of the features to be patterned in the substrate will be reduced when compared with the features patterned at the identical value of dose set at the scanner in the absence of a multi-layer stack. Typically, when the absorption point of each photon is mapped individually, a noise is obtained compared to a continuous aerial image of light absorption. The more photons there would be, the closer the particle representation will be to the aerial representation. Therefore, it is for this reason that increased photon absorption would reduce photon shot noise. Due to the fact that this photon shot noise is partially responsible for LWR, reducing this noise would imply reduction of the LWR.

Enhancement of EUV photoresist sensitivity by sending back EUV photons achieved according to embodiments of the present disclosure is advantageous in comparison to sending secondary electrons back to the EUV photoresist layer by using an underlayer. This is due to the fact that only about 5 nm at the bottom of the EUV photoresist layer would take advantage of sensitivity enhancement. Typically, for positive-tone developer photoresists, this short ranged benefit is due to the short thermalization distance of the secondary electrons and this would then likely pose a risk of dissolution at the interface, thereby leading to pattern collapse. On the other hand, for negative-tone developer photoresists, a potential risk is to have large footing at the bottom of the photoresist features. Thus, whether a positive-tone or a negative-tone developer photoresist is used, profile of the photoresist is impacted in either of the cases. Present disclosure is further advantageous in comparison to the use of photo-acid generators due to the fact that it can lead to problems or challenges with respect to LER and/or resolution of patterned features in the substrate.

In embodiments, the refractive index of the first material may be higher than that of the second material and the first layer of the first material of the multi-layer stack may be in direct contact with the EUV photoresist layer. It is advantageous that the layer of the material having higher refractive index is in contact with the EUV photoresist layer since it leads to the formation of higher amount of reflections from successive layers, thus having a higher chance of enhancing EUV sensitivity.

The refractive index of the first material may be lower than that of the second material, and the first layer of the first material of the multi-layer stack may be in direct contact with the EUV photoresist layer.

In embodiments, the EUV photolithographic processing is done at a wavelength in the range of 6 nm to 27 nm. It is advantageous to perform EUV processing at a wavelength in this range since it provides a broad wavelength range that may present more options for tackling EUV lithography related problems.

In embodiments, the difference in the refractive index of the first layer and the second layer is between 1 % and 15 %. It is advantageous that the refractive indexes of the layers are as far apart as possible from each other so that enough contrast exists in between the refractive indexes and so as to enhance the EUV photoresist sensitivity.

In the present invention, the multi-layer stack is a self-organized di-block copolymer. It is advantageous to use the di-block copolymer as the multi-layer stack since it does not require repetitive deposition steps of the first layer and the second layer. The first material of the first layer of the self-organized di-block copolymer may be a first polymer component containing silicon or silicon and a metal while the second material of the second layer may be a second polymer component. Having the first polymer component containing silicon or silicon and a metal will increase the refractive index compared to the second polymer component. This will allow for enhancing reflections of the EUV light from each of the interfaces between the first layer and the second layer.

In the present invention, the multi-layer stack is a self-organized di-block copolymer. The first material of the first layer may be a first polymer component containing a metal or a metal oxide and the second material of the second layer may be a second polymer component. It is advantageous to use the di-block copolymer as the multi-layer stack since it does not require repetitive deposition steps of the first layer and the second layer. Furthermore, it requires an easy process to provide the self-organized di-block copolymer, where the first material of the first layer may be a first polymer component containing a metal or a metal oxide.

The metal oxide may be a ceramic material.

The ceramic material may be any material that may be grown by Atomic layer Deposition (ALD) technique such as for example, aluminum oxide, titanium oxide, hafnium oxide, zirconium oxide, zinc oxide, or silicon oxide.

The multilayer stack may be a self-organized high-chi di-block copolymer. The first material of the first layer may be a first polymer component and the second material of the second layer may be a second polymer component.

In embodiments, providing the self-organized di-block copolymer as the multi-layer stack wherein the first material of the first layer may be a first polymer component containing a metal or a ceramic material comprises depositing a self-organizing di-block copolymer consisting of the first polymer component and the second polymer component, phase separating the self-organizing di-block copolymer and infusing the first polymer component with the metal or the metal oxide. Infusing the first polymer component with metal or metal oxide helps to create sufficient difference in the real part "n" of the refractive indexes such that EUV photosensitivity can be obtained.

Preferably, the metal may be aluminum.

Preferably, the metal oxide may be aluminum oxide.

In embodiments, the first material of the first layer and the second material of the second layer may have the their refractive indexes in the range from 0.85 to 1.05 at 13.5 nm wavelength.

In embodiments, the method may further comprise patterning the multi-layer stack by etching through the at least one opening in the EUV photoresist layer. After removing the EUV photoresist layer, the substrate may be patterned using the patterned multilayer stack as a hard mask. It is advantageous that the multilayer stack may also be used as the hard mask since this simplifies the process flow such that the need for having extra hard mask layer is moot.

In a second aspect, the present disclosure relates to an intermediate structure. The intermediate structure comprises a substrate having an upper main surface and a multi-layer stack on the main surface. The multi-layer stack is a self-organized di-block copolymer, and consists of a first layer of a first material and a second layer of a second material. The materials have a different refractive indexes and the layers are stacked alternately and repeatedly in one another. The intermediate structure further comprises an EUV photoresist layer, where the multi-layer stack is in contact and is sandwiched between the EUV photoresist layer and the upper main surface of the substrate.

In embodiments, the refractive index of the first material may be higher than that of the second material, and the first layer of the first material of the multi-layer stack may be in direct contact with the EUV photoresist layer. It is advantageous to have the layer of the material having higher refractive index in contact with the EUV photoresist layer, since it leads to the formation of higher amount of reflections from successive layers, thus having an EUV photoresist layer with enhanced EUV sensitivity.

The refractive index of the first material may be lower than that of the second material, and the first layer of the first material of the multi-layer stack may be in direct contact with the EUV photoresist layer.

In embodiments, the difference in the refractive index of the first layer and the second layer may be between 1 % and 15 %. It is advantageous that the refractive indexes of the layers are as far apart as possible from each other so that enough contrast exists in between the refractive indexes and so as to enhance the EUV photoresist sensitivity.

In embodiments, the first layer and the second layer may have the refractive indexes in the range of 0.85 and 1.05 at 13.5 nm wavelength. from the dependent claims may be combined with features of the independent claims and with features of other dependent claims insofar as covered by the scope of the claims.

Although there has been constant improvement, change and evolution of devices and methods in this field, the present concepts are believed to represent substantial new and novel improvements, including departures from prior practices, resulting in the provision of more efficient, stable and reliable devices or methods of this nature.

The above and other characteristics, features and advantages of the present disclosure will become apparent from the following detailed description, taken in conjunction with the accompanying drawings, which illustrate, by way of example, the principles of the disclosure. This description is given for the sake of example only, without limiting the scope of the disclosure. The reference figures quoted below refer to the attached drawings.

**Brief description of the figures**

**Fig. 1** is a flowchart representing a method according to an embodiment of the present disclosure.
**Fig. 2a to Fig. 2c** show a schematic representation of process
steps, in order, as used in the embodiments of the present disclosure.
**Fig. 3** shows prior art optical properties refraction index, n) of the first 82 elemental atoms at 13.5 nm wavelength.
**Fig. 4** (Reference Example) shows PROLITH simulation of the relation between the number of MoSi pair in a multi-layer stack used as underlayer and the number of photon absorbed by an EUV photoresist layer according to an embodiment.
**Fig. 5** shows aerial image of the light intensity in the EUV photoresist layer: (a) resist on a traditional substrate, (b) resist with a multi-layer stack composed of 20 layers of material with $n_1 = 1.01$ and $n_2 = 0.97$ according to an embodiment.
**Fig. 6** is a flowchart representing a method according to an embodiment of the present disclosure.
**Fig 7a to Fig. 7d** shows a schematic representation of process steps, in order, as used in further embodiments of the present disclosure.
**Fig. 8** shows an intermediate structure obtained according to the embodiments of the present disclosure.

The figures are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

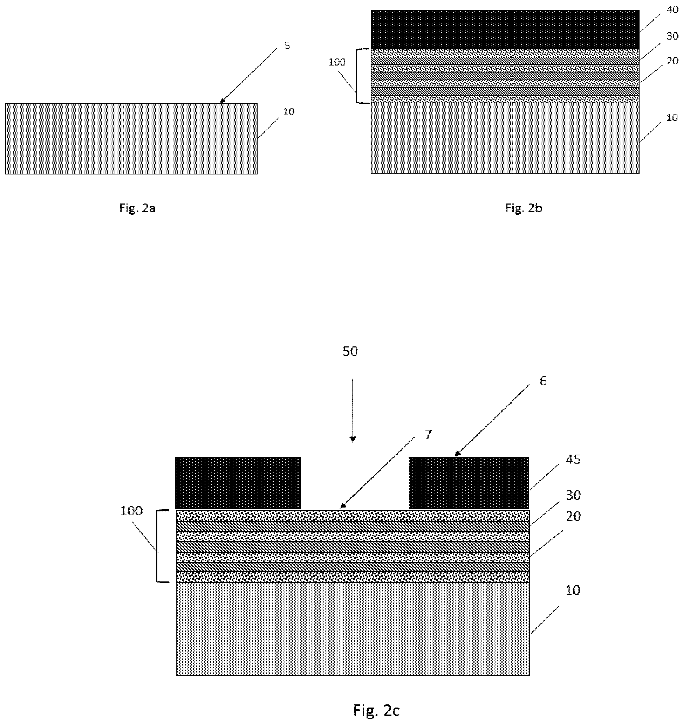

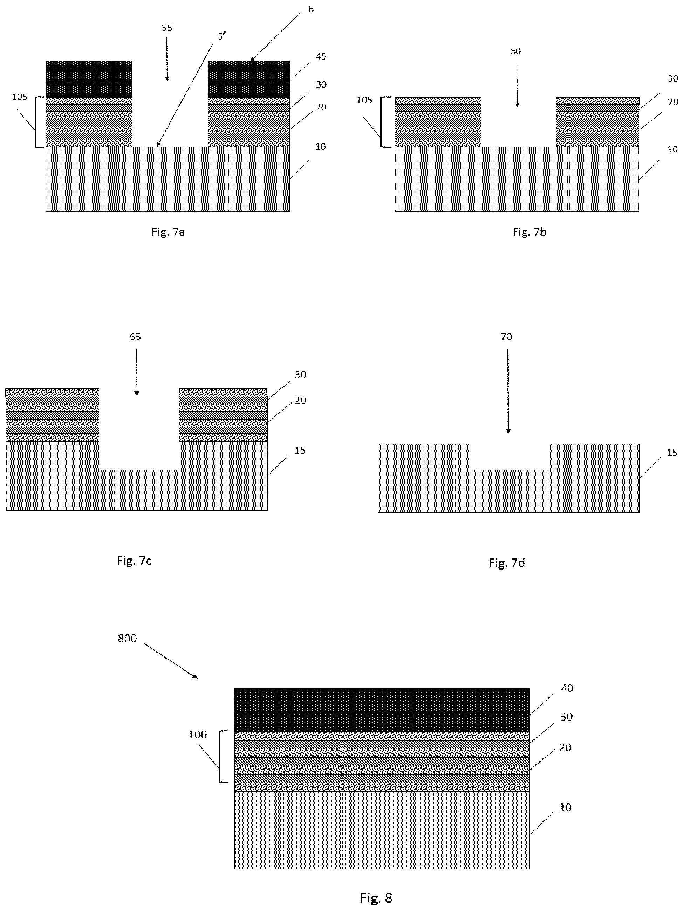

**Fig. 2 and Fig. 7** show corresponding cross-sections of the substrate at different stages of the method. Purely to facilitate understanding, different layers are shown with different filling patterns. This should not be construed in any limiting sense.

**Detailed description of the disclosure**

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the disclosure.
It is to be noticed that the term *"comprising",* used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof.
Reference throughout the specification to "one embodiment" or "an embodiment" means that a particular feature, structure or characteristic described in connection with the embodiment is included in at least one embodiment of the present disclosure. Thus, appearances of the phrases "in one embodiment" or "in an embodiment" in various places throughout the specification are not necessarily all referring to the same embodiment, but may. Furthermore, the particular features, structures or characteristics may be combined in any suitable manner, as would be apparent to one of ordinary skill in the art from the disclosure, in one or more embodiments.
Similarly it should be appreciated that in the description of exemplary embodiments of the disclosure, various features of the disclosure are sometimes grouped together in a single embodiment, figure, or description thereof for the purpose of streamlining the disclosure and aiding in the understanding of one or more of the various inventive aspects. The method of disclosure, however, is not to be interpreted as reflecting an intention that the claimed disclosure requires more features than are expressly recited in each claim. Rather, as the following claims reflect, inventive aspects lie in less than all features of a single foregoing disclosed embodiment. Thus, the claims following the detailed description are hereby expressly incorporated into the detailed description, with each claim standing on its own as a separate embodiment of the disclosure.
Furthermore, while some embodiments described herein include some but not other features included in other embodiments, combinations of features of different embodiments are meant to be within the scope of the disclosure, and form different embodiments, insofar as covered by the scope of the claims.

In the description provided herein, numerous specific details are set forth. However, it is understood that embodiments of the disclosure may be practiced without these specific details. In other instances, well-known methods, structures and techniques have not been shown in detail in order not to obscure an understanding of the description.

The following terms are provided solely to aid in the understanding of the disclosure.

As used herein and unless provided otherwise, *refractive index* refers to the real part "n" of the complex refractive index.

As used herein and unless provided otherwise, *path length* difference refers to the optical path length difference, which is determined by the product of the geometric path length of the light and the index of refraction of the medium through which it propagates. Geometric path length is a function of the thickness of the layer through which the refracted light passes. Thus, in case of normal incidence, for example when light is directed normal to the surface of the layer, geometrical path length is approximately equal to twice the film thickness, 2(t) since refracted light passes through the film thickness (t) twice.

As used herein and unless provided otherwise, *a di-block copolymer* refers to a block copolymer having two different homo polymers A and B that are linked via a covalent bond.

As used herein and unless provided otherwise, *a high-chi block copolymer* refers to a di-block copolymer having a high value of Flory-Huggins interaction parameter.

As used herein and unless provided otherwise, *lamella* refers to ordered micro-phase structures that are formed during the micro-phase separation of the block copolymer.

As used herein and unless provided otherwise, *thermalization distance* refers to the distance between a secondary electron and its originating cation where it has lost enough energy and is at equilibrium.

As used herein and unless provided otherwise, *footing* refers to the non-straight profile of any feature, where the width at the bottom region of the feature is wider than the width at the upper region.

As used herein and unless provided otherwise, *throughput* refers to productivity of a process expressed over a unit period.

The disclosure will now be described by a detailed description of several embodiments of the disclosure. It is clear that other embodiments of the disclosure can be configured according to the knowledge of persons skilled in the art without departing from the technical teaching of the disclosure, the disclosure being limited only by the terms of the appended claims.

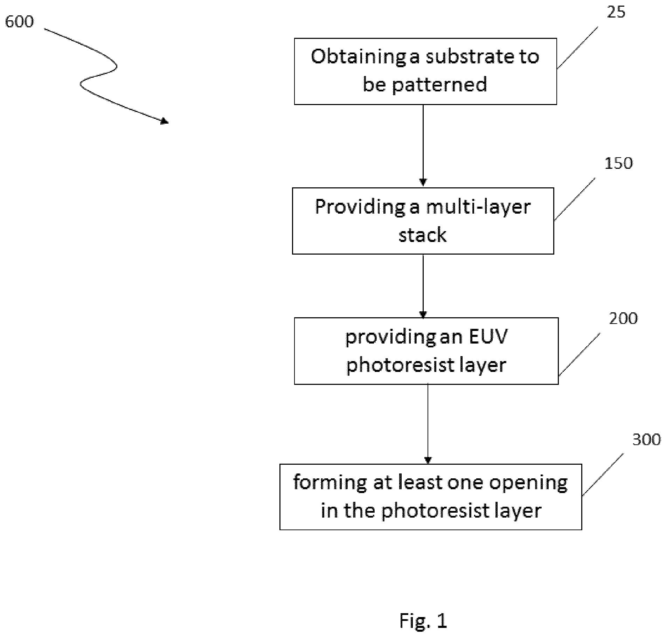

We now refer to **Fig. 1** showing a flowchart representing a method according to an embodiment of the present disclosure, to be read in combination with **Fig. 2** showing a schematic representation of the corresponding cross sections of the substrate after process steps, in order, as used in the embodiments of the present disclosure.

The method (600) starts with obtaining (25) a substrate (10) to be patterned (**Fig. 2a**). The substrate (10) has an upper main surface (5). The upper main surface (5) may be in contact with surrounding ambient.

In embodiments, the substrate may include any underlying material or materials that may be used, or upon which a device may be formed.

In embodiments, the substrate may be a semiconductor substrate suitable for manufacturing semiconductor devices. The semiconductor substrate may be a bulk semiconductor substrate, such as for example, Si, Ge, gallium arsenide (GaAs), a gallium arsenide phosphide (GaAsP), an indium phosphide (InP) or a silicon germanium (SiGe) substrate.

In embodiments, the substrate may comprise different semiconductor layers stacked on top of one another, such as for example silicon germanium (SiGe) vs. germanium (Ge) or silicon (Si) vs. silicon germanium (SiGe).

In embodiments, the substrate may include for example an insulating layer such as a $SiO_2$ or a $Si_3N_4$ layer in addition to a semiconductor substrate portion. Thus, the substrate may also be silicon-on-glass, silicon-on sapphire, silicon-on-insulator (SOI) substrate or germanium-on-insulator (GeOI) substrate.

In one particular embodiment, the substrate may have a main surface of monocrystalline silicon layer. In this particular embodiment, fin structures may be patterned in the substrate (10).

An EUV photoresist layer (40) is provided (200) on the upper main surface (5) by methods known to persons skilled in the art. At least one opening (50) is formed (300) in the EUV photoresist layer (40), thereby forming a patterned EUV photoresist layer (45) **(Fig. 2c)**. Formation of the at least one opening (50) is done by the methods known to persons skilled in the art.

In embodiments, the EUV photolithographic processing may be done at a wavelength in the range of 6 nm to 27 nm. It is advantageous to perform EUV processing at a wavelength in this range since it provides a wavelength range capable of presenting options for tackling EUV lithography related problems. For example, different combinations of elemental atoms may be chosen to be used in the multi-layer stack that have potential to provide enhancement of EUV photoresist sensitivity at wavelengths covered in this range.

A multi-layer stack (100) is provided (150) sandwiched between and in contact with the EUV photoresist layer (40) and the upper main surface (5) of the substrate (10) **(Fig. 1 and Fig. 2b).** The multi-layer stack (100) has an upper surface and is a self-organized di-block copolymer.

The at least one opening (50) extends from a top surface (6) of the EUV photoresist layer (40) down to the upper surface of the multi-layer stack (100), thereby exposing a part (7) of the upper main surface of the multi-layer stack **(Fig. 2c)**.

The multi-layer stack (100) consist of a first layer (20) of a first material and a second layer (30) of a second material and the first material and the second material may have different refractive indexes. The first layer (20) and the second layer (30) are stacked alternately and repeatedly on one another (Fig. 2b).

A combination of the first layer (20) and the second layer (30) is called a pair. Increasing the numbers of such pairs, thus stacking the first layer (20) and the second layer (30) repeatedly is advantageous since it increases reflectivity due to the reflections occurring at each interface between the first layer (20) and the second layer (30). Increasing the refractive index contrast, thus stacking the first layer (20) and the second layer (30), which have different refractive indexes, alternatingly leads to an increase both in reflectivity and bandwidth. It is thus advantageous to have the first material and the second material having different refractive indexes. It is thus further advantageous to have as a difference as large as possible in the refractive index of the first material and the second material.

In embodiments, the difference in the refractive index of the first layer and the second layer may be between 1 % and 15 %. It is advantageous that the refractive indexes of the layers are as far apart as possible from each other in order so that enough contrast exists in between the refractive indexes and so as to enhance the EUV photoresist sensitivity.

Consequently, EUV light reflected at each interface between the first layer (20) and the second layer (30) will enter back into the EUV photoresist layer, thereby enhancing its photosensitivity.

The amount of reflected EUV light, thus the peak reflectance value, entering back into the EUV photoresist layer (40) depends upon the ratio of the refractive index of the first layer (20) and the second layer (30), as well as the number of layer pairs. Thus, the peak reflectance may be increased by adding more layers or by using layers of materials with a higher refractive index ratio.

For multi-layer stacks consisting of repeated and alternating layers of high and low refractive index materials, optical path length is equal to quarter wavelength of the incident light. Thus, reflectance is a maximum at the wavelength for which both the high refractive index and the low refractive index layers of the multilayer stack are exactly one quarter wave thick.

Optical path length difference ($\Delta$) in a layer of the multilayer stack is determined by the product of the geometric path of the light and the index of refraction **(n)** of the medium through which it propagates. For EUV light, having a wavelength $\lambda$, arriving at normal incidence to the surface, the optical path length difference is approximately equal to twice the film thickness **(t)** and the following equation would hold for producing constructive interference :

$$(\Delta) \ = \ 2n(t) \ = \ \lambda/4$$

$$n(t) \ = \ \lambda/2 \qquad\qquad (Eq.1)$$

Thus, the thickness of the layer is also an important factor. Therefore, multi-layer stacks having layers whose product of refractive index and thickness is equal to half the wavelength of EUV wavelength is advantageous in embodiments of the present disclosure.

When light passes through a medium, some part of it will always be attenuated such that there will be a gradual loss in intensity of any kind of flux through a medium. This is usually taken into account by defining a complex refractive index expressed as :

$$\underline{n} \ = \ n \ + \ ik \qquad\qquad (Eq.2)$$

where the real part "n" is the refractive index and indicates phase velocity and the imaginary part "k" is called the extinction coefficient. Extinction coefficient relates to the reduction in multilayer reflectivity. Therefore, it is advantageous to have a pair with the first material and the second material having a low value for their extinction coefficients, k, such that reduction in multilayer reflectivity would be minimized.

The first layer (20) or the second layer (30) of the multi-layer stack (100) may be present in contact with the EUV photoresist layer (40).

In embodiments, the layer that has the higher refractive index may be in contact with the EUV photoresist layer (40). It is advantageous that the layer of the multi-layer stack having a higher refractive index is in direct contact with the EUV photoresist layer (40) since this allows for more reflections to be created at the interfaces of the first layer (20) and the second layer (30) of the multi-layer stack. More reflections that are coupled constructively leads to improvement of EUV photoresist sensitivity.

The layer that has the lower refractive index may be in contact with the EUV photoresist layer (40). In this case, use of more number of pairs in the multi-layer stack (100) or adapting the thickness of each of the layers is the multi-layer stack may allow for creating more reflections at the interfaces of the first layer (20) and the second layer (30) of the multi-layer stack (100).

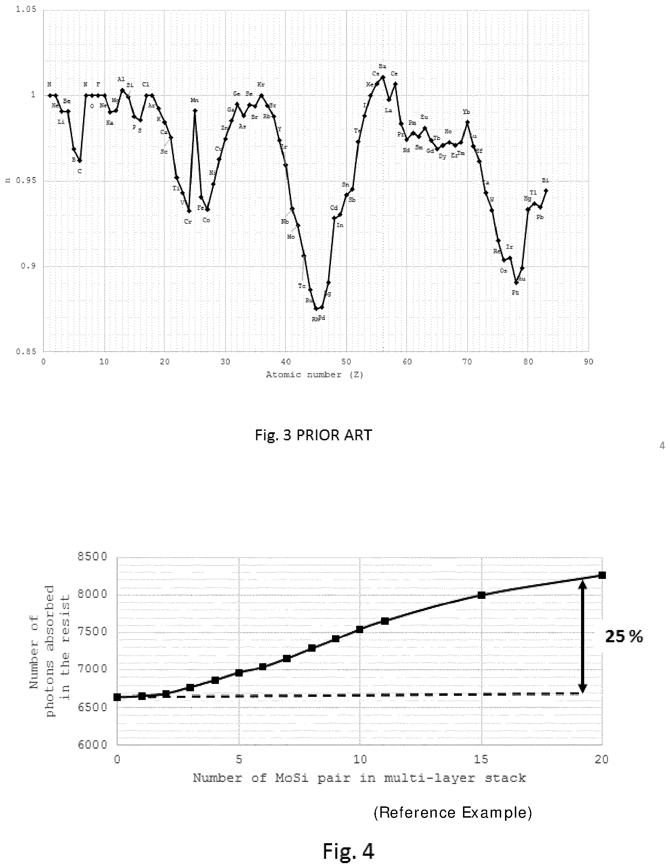

**Fig. 3** shows prior art optical properties (refractive index, n) of the first 82 elemental atoms at 13.5 nm wavelength. 13.5 nm is the wavelength currently used for EUV lithographic processing in semiconductor manufacturing. **Figure 3** permits to identify pairs that are suitable for making the multi-layer stack as disclosed in this disclosure for use in EUV lithographic processing of semiconductor manufacturing carried out in a cleanroom environment. The figure presents wide range of elemental atoms that can be combined as a pair and it is advantageous to choose combinations wherein the difference in the refractive index of the first layer and the second layer may be between 1 % and 15 %. It is advantageous that the refractive indexes of the layers are as far apart as possible from each other in order so that enough contrast exists in between the refractive indexes and so as to enhance the EUV photoresist sensitivity. It is further of advantage if each elemental atom in such a pair satisfying this condition has extinction coefficients lower than 0.04, preferably lower than 0.02, and yet preferably lower than 0.01.

As a Reference Example, **Fig. 4** shows, a PROLITH simulation of the relation between the number of MoSi pairs in a multi-layer stack and the number of photons absorbed by an EUV photoresist layer. The simulation region has been taken to be $80 \times 80 \times 40$ nm$^3$. It is observed that as the number of MoSi pairs increases, the number of absorbed photons increases in the EUV photoresist layer. There exits about 25 % increase in photon absorption when, for example, 20 MoSi pairs are used as a multilayer stack in comparison to the case when no multi-layer stack consisting of MoSi pairs were used.

To be used as a reflector under an EUV photoresist layer, a high reflectance may not be necessary. It may be sufficient to obtain enhancement in reflectance such that a reduction of 10-30 % could be obtained in the dose at the scanner level. From photon absorption point of view, at least 10% increase in absorption in the EUV photoresist layer may be targeted Therefore, fewer number of pairs may be sufficient and the material selection of the first layer (20) and the second layer (30) need not be Mo/Si or limited thereof. The material selection may depend on the trade-off between how easy vs. how cheap it would be to form the multi-layer stack. Besides, the easiness in etching of the multi-layer stack should also be considered. This consideration is important if the multilayer stack will be used as a hard mask layer.

The multi-layer stack (100) of the present invention is a self-organized di-block copolymer. The first material of the first layer of the self-organized di-block copolymer may be a first polymer component containing silicon or silicon and a metal. The second material of the second layer of the self-organized di-block copolymer may be a second polymer component.

The multi-layer stack (100) is a self-organized di-block copolymer. The first material of the first layer of the self-organized di-block copolymer may be a first polymer component containing silicon and the second material of the second layer of the self-organized di-block copolymer may be a second polymer component containing a metal. The metal, in these embodiments, may for example, be Mo. The self-organized di-block copolymer having the first polymer component containing silicon and having the second component containing Mo may possess the desired reflective properties for EUV photoresist sensitivity enhancement.

In an example, the self-organized di-block copolymer may be PS-b-PMMA, where silicon may be contained in PMMA, since typically, PMMA is easy to modify.

It is advantageous that the first polymer component contains silicon or silicon and the metal, since in this way refractive index of the domains originating from the first polymer component will be higher than the refractive index of the domains originating from the second polymer component, which contain mostly carbon atoms.

In alternative embodiments, the first material of the first layer of the self-organized di-block copolymer may be a first polymer component containing a metal or a metal oxide. The second material of the second layer of the self-organized di-block copolymer may be a second polymer component.

In embodiments, the metal oxide may be a ceramic material. In embodiments, the ceramic material may be any ceramic material that may be grown by Atomic layer Deposition (ALD) technique such as for example but not limited to, aluminum oxide, titanium oxide, hafnium oxide, zirconium oxide, zinc oxide, or silicon oxide.

In an example, the self-organized di-block copolymer may be PS-b-PMMA, where metal may be contained in PMMA, since typically, PMMA is easy to modify.

In an example, the self-organized di-block copolymer may be PS-b-PMMA, where metal oxide may be contained in PMMA, since typically, PMMA is easy to modify.

It is advantageous that the first polymer component contains the metal or the metal oxide since in this way refractive index of the domains originating from the first polymer component will be higher than the refractive index of the domains originating from the second polymer component, which contain mostly carbon atoms.

Therefore, self-organized di-block copolymer having the first polymer component, which has silicon, silicon and metal, or ceramic material and the second polymer component will be aligned alternatingly and repeatedly. This will create the multi-layer stack of layer of materials having different refractive indexes, thereby helping to enhance EUV photoresist sensitivity due to more reflections of EUV light at each interface between the material layers.

The multi-layer stack of the self-organized di-block copolymer having the first polymer component containing a metal or a ceramic material and the second polymer component may be provided by depositing a self-organized di-block copolymer on the main surface of the substrate (10). The self-organized di-block copolymer may consist of the first polymer component and the second polymer component. Micro phase separation takes place as a result of a thermal annealing process, thus forming the domains. Subsequently, sequential infiltration synthesis (SIS) technique may be used, as known to persons skilled in the art, in order to infuse selectively elemental atoms of preference into one of the domains, for example the first polymer component, or to convert one of the domains, for example the first polymer component, into a metal oxide of preference.

In embodiments, the metal oxide may be a ceramic material, such as for example, Al2O3. In embodiments, the ceramic material may also be any ceramic material that may be grown by Atomic layer Deposition (ALD) technique such as for example, aluminum oxide, titanium oxide, hafnium oxide, zirconium oxide, zinc oxide, or silicon oxide.

The orientation of the di-block copolymer domains with respect to the substrate is crucial for the application disclosed in the present disclosure. Therefore, in embodiments, lamella lying parallel to the main surface of the substrate (10) may be preferred. The di-block copolymer may be designed such that lamella lying parallel to the main surface of the substrate (10) may be obtained. Once the self-organized di-block copolymer is provided on the main surface (5) of the substrate (10), it will be confined in between free surface, for example air, and the main surface of the substrate (10). Due to the chemically distinct nature of each polymer block, the different interactions of each block at the surface give rise to a preferential segregation of one of the blocks to the main surface (5) after phase separation. Parallel orientation of the lamellae will be induced due to the enrichment of one of the polymer blocks at the main surface and the parallel orientation will propagate into the film. Typically, when the thickness of the self-organized di-block copolymer is higher than its natural periodicity, typically denoted by $L_0$, lamella lying parallel to the main surface of the substrate is likely to be obtained after phase separation.

Typically, the surface effects become less dominant away from the main surface of the substrate and thus, a parallel orientation can only be achieved throughout the film if the film is thin enough. When the di-block copolymer has preferential wetting with respect to both the main surface of the substrate and the free surface (e.g. air), one of the polymer components tends to segregate to both surfaces thus, forming a layer of the first polymer component of thickness of dp/4 at each surface. The total film thickness is therefore equal to integer of the lamellar period dp of the copolymer.

Additionally, the total thickness (t) of the self-organized di-block copolymer multiplied by its refractive index should satisfy the following equation for an EUV photolithographic process carried out at 13.5 nm wavelength:

$$n(t) = \lambda/2 = 6.7 \text{ nm} \qquad (Eq.3)$$

In embodiments, the multi-layer stack may be a self-organized *high-chi* di-block copolymer. The self-organized high-chi material may be chosen such that its *chi* parameter is high enough to accomplish $L_0 = \lambda/2$ , where $\lambda$ is the wavelength of the EUV photolithographic processing The first material of the first layer of the self-organized *high-chi* di-block copolymer may be a first polymer component. The second material of the second layer of the self-organized *high-chi* di-block copolymer may be a second polymer component. It is advantageous to have a self-organized *high-chi* di-block copolymer since domains of the *high-chi* di-block copolymer may provide the required refractive index contrast. It is further advantageous to have a self-organized *high-chi* di-block copolymer since they have a tendency to spontaneously form parallel oriented lamellae due to preferential wetting of both the main surface of the substrate and the free surface, for example air.

It is advantageous that the multi-layer stack may be a self-organized di-block copolymer since the self-organized di-block copolymer can be easily deposited on the substrate (10) without requiring multiple deposition steps. A di-block copolymer may be deposited by spin coating on the substrate (10). After deposition, following a thermal annealing process, the spin-coated di-block copolymer phase separates, thereby forming domains of the first polymer component and the second polymer component.

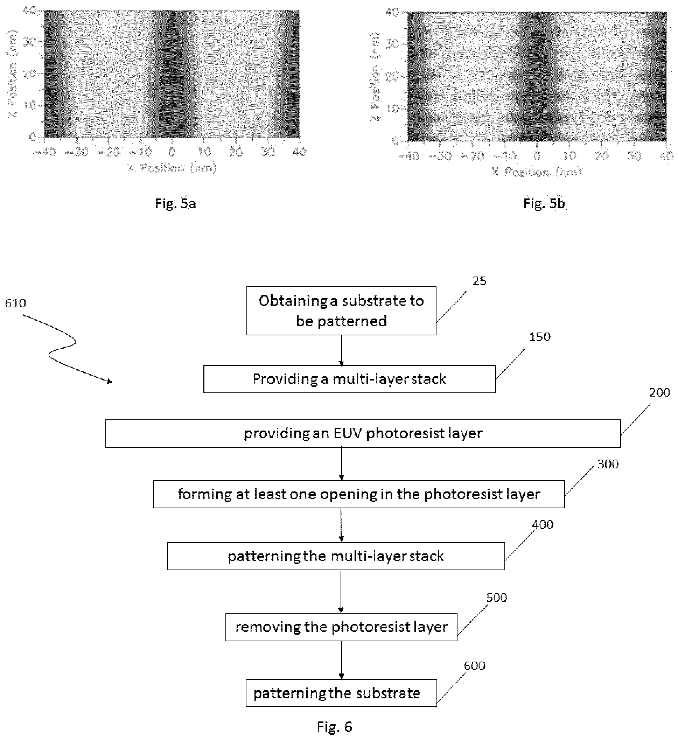

**Fig. 5** shows aerial image of the light intensity in the EUV photoresist layer. A comparison is made between an EUV photoresist layer on a traditional substrate, which is silicon , **(FIG. 5a)** and an EUV photoresist having a multi-layer stack underneath that is composed of 20 layers of material with a refractive index of $n_1 = 1.01$ and $n_2 = 0.97$, according to an embodiment. A refractive index of 1.01 may, for example, correspond to that of silicon or aluminum or a Spin-On Glass, while a refractive index of 0.97 may, for example, correspond to that of a PMMA domain of a di-block copolymer, or a Spin-On Carbon. Thus, this example may, for example, represent a self-organized di-block copolymer, wherein the first material of the first layer is a first polymer component containing a metal such as Aluminum and the second material of the second layer is a second polymer component, which is PMMA according to one of the embodiments of the present disclosure. The image shows that the intensity of the EUV light in the photoresist layer is higher (Fig. 5b) in the presence of the reflective multi-layer stack underneath the EUV photoresist layer in comparison to the situation where there is no multi-layer stack underneath **(Fig. 5a).**

We now refer to **Fig. 6** showing a flowchart representing a method according to an embodiment of the present disclosure in combination with **Fig. 7** showing a schematic representation of the corresponding cross sections of the substrate after process steps, in order, as used in the embodiments of the present disclosure.

The steps (400), (500) and (600) of the method (610) illustrated in Fig. 6 may be performed subsequent to the step (300) of the method (600) illustrated in **Fig. 1.**

With reference to **Fig. 6 and Fig. 7a,** the method (610) may further comprise patterning(400) the multi-layer stack (100) by etching through the at least one opening (50) in the EUV photoresist layer, thereby forming a patterned multi-layer stack (105) having an opening (55). The opening (55) exposes at its bottom a part (5') of the main surface (5) of the substrate (10). The etching of the multi-layer stack may be performed as known to persons skilled in the art. The method (610) further comprises removing the photoresist layer (45) **(Fig. 7b),** thereby obtaining the patterned multi-layer stack (105) on the substrate (10). The patterned multi-layers stack (105) may be used as a hard mask layer for further patterning of the substrate (10). The substrate (10) is patterned by performing an etch process and etching the substrate through the opening (60) in the patterned multi-layer stack (105) **(Fig. 7c),** thereby forming an opening (65). The multilayer stack may be removed after completing the etching process, thereby forming a patterned substrate (15) having at least an opening (70) **(Fig. 7d).**

The choice of the layers of the multi-layers stack is, thus, important such that etching characteristics should be considered so that the multi-layer stack has properties suitable for a hard mask and thus can be used as a hard mask.

It is advantageous to use the multi-layers stack as a hard mask since this may help to eliminate the problem of EUV photoresist layer consumption. As industry is moving to the implementation of EUV lithographic processing due to shrinkage in feature sizes, photoresist thicknesses are being reduced. This in turn results in additional challenges such as the consumption of the EUV photoresist layer especially when patterning high aspect ratio features in the substrate. By using a multi-layer stack as disclosed in the present disclosure, not only EUV photoresist sensitivity is enhanced but at the same time EUV photoresist consumption does not pose a challenge anymore since patterning of the substrate will be facilitated by the presence of the patterned multi-layer stack, which may be used as a hard mask.

We now refer to **Fig. 8** showing a cross section of an intermediate structure (800). The intermediate structure (800) comprises a substrate (10) having an upper main surface. A multilayer stack (100) is present directly on and in contact with the upper main surface. The multilayer stack (100) is a self-organized di-block copolymer and consists of a first layer (20) of a first material and a second layer (30) of a second material. The materials have different refractive indexes, and the layers (20, 30) are stacked alternately and repeatedly on one another. The multi-layer stack (100) further comprises an EUV photoresist layer (40) directly on and in contact with the multilayer stack (100). The multi-layer stack is, thus, situated sandwiched in between and in contact with the EUV photoresist layer (40) and the upper main surface of the substrate (10).

In embodiments, the refractive index of the first material may be higher than that of the second material, and the first layer (20) of this first material of the multi-layer stack may be in direct contact with the EUV photoresist layer (40).

In alternative embodiments, the refractive index of the first material may be higher than that of the second material, however, the second layer (30) of the second material of the multi-layer stack may be in direct contact with the EUV photoresist layer (40). This is also advantageous. Even though there will be little reflectance generated at the interface between the EUV photoresist layer and the second layer of the multi-layer stack, there will be enough reflectance created at all other subsequent interfaces to provide the enhanced EUV photoresist sensitivity.

The EUV photoresist layer (40) may have a thickness suitable for EUV lithographic processing.

In embodiments, the difference between the refractive index of the first layer and the second layer may be between 1 % and 15 %. It is advantageous that the refractive indexes of the layers are as far apart as possible from each other in order so that enough contrast exists in between the refractive indexes and so as to enhance the EUV photoresist sensitivity. Although a weak EUV photoresist sensitivity maybe experienced with layers having a refractive index difference of 1 %, it still presents to be advantageous in comparison to cases where no multi-layer stack is used.

Within these classes of materials offering combinations to be used as a multi-layer stack, it is advantageous, in embodiments of the disclosure, that candidate materials to be used as the first layer (20) and the second layer (30) may have refractive indexes in the range of 0.85 and 1.05 at 13.5 nm wavelength since EUV lithography is currently performed at 13.5 nm in semiconductor manufacturing. Among these candidate materials having refractive indexes in the range of 0.85 and 1.05 at 13.5 nm wavelength, it is a further advantage if the materials possess low values of extinction coefficients. In embodiments, the extinction coefficient of these candidate materials may be lower than 0.08, preferably lower than 0.06. In embodiments, the extinction coefficient may yet preferably be lower than 0.04 and even more preferably lower than 0.02.

In embodiments, the first material of the first layer (20) and the second material of the second layer (30) may be an organic polymer. The organic polymer of the first layer (20) and/or the second layer (30) may be doped with a dopant element. The dopant element may be chosen from among the ones presented in Fig. 3. The dopant type and/or the dopant concentration may be adjusted such that a refractive index difference in the range of 1 % to 15 % exists between the first layer (20) and the second layer (30).

The multi-layer stack (100) is a self-organized di-block copolymer. The first material of the first layer of the self-organized di-block copolymer may be a first polymer component containing silicon or silicon and a metal while the second material of the second layer may be a second polymer component. Having the first polymer component containing silicon or silicon and a metal will increase the refractive index compared to the second polymer component. This will allow for enhancing reflections of the EUV light from each of the interfaces between the first layer and the second layer.

In embodiments, the first polymer component containing silicon or silicon and a metal may be the layer of the multi-layer stack that is in direct contact with the EUV photoresist layer (40).

In the present invention, the multi-layer stack is a self-organized di-block copolymer. The first material of the first layer may be a first polymer component containing a metal or a metal oxide and the second material of the second layer may be a second polymer component.

In embodiments, the first polymer component containing a metal or metal oxide may be the layer of the multi-layer stack (100) that is in direct contact with the EUV photoresist layer (40).

In embodiments, the multi-layer stack may be a self-organized *high-chi* di-block copolymer. The first material of the first layer of the self-organized *high-chi* di-block copolymer may be a first polymer component. The second material of the second layer of the self-organized *high-chi* di-block copolymer may be a second polymer component.

The first layer (20) and the second layer (30) of the multilayer stack (100) make up a pair and the total thickness of the multi-layer stack depends on the total number of these pairs. The relative thicknesses of the first layer (20) and the second layer (30) in the multi-layer stack (100) are also critical for having an optimized reflectivity.

For multi-layer stacks consisting of repeated and alternating layers of high and low refractive index materials, optical path length difference is equal to quarter wavelength of the incident light, which is also equal to the product of the geometric path length of the refracted light and the refractive index of the medium in which it travels. Reflectance is a maximum at the wavelength for which both the high refractive index and the low refractive index layers of the multi-layer stack are exactly one quarter wave thick.

Thus, the following would hold :

$$2n_1(t_1) = \lambda/4 \qquad\qquad (Eq. \ 4)$$

and

$$2n_2(t_2) = \lambda/4 \qquad\qquad (Eq. \ 5)$$

where $n_1$, $n_2$, $t_1$, and $t_2$ refer to the refractive index and the thickness of the first layer and of the second layer, respectively.

The peak reflectance that would be observed in the EUV photoresist layer (40) may be increased by adding more layers or more number of pairs or by using layers of materials with a higher refractive index ratio.

**Claims**

1. A method for performing an extreme ultraviolet (EUV) photolithographic processing, the method comprising:

   - obtaining a substrate (10) to be patterned having an upper main surface (5),
   - providing an EUV photoresist layer (40) on the upper main surface (5), and;
   - forming at least one opening (50) in the EUV photoresist layer (40), wherein the method further comprises, providing, sandwiched between the EUV photoresist layer (40) and the upper main surface (5), a multi-layer stack (100) having an upper surface and consisting of a first layer (20) of a first material and a second layer (30) of a second material, wherein the materials have a different refractive indexes, and the layers are stacked alternately and repeatedly on one another, and wherein the at least one opening (50) exposes a part (7) of the upper main surface of the multi-layer stack,
   **characterized in that**;
   the multi-layer stack (100) is a self-organized di-block copolymer.

2. The method according to claim 1, wherein

   - the refractive index of the first material is higher than that of the second material, and

- the first layer (20) of the first material of the multilayer stack is in direct contact with the EUV photoresist layer (40) and wherein the EUV photolithographic processing is done at a wavelength in the range of 6 nm to 27 nm.

3. The method according to claim 2, wherein the difference in the refractive index of the first layer (20) and the second layer (30) is between 1 % and 15 %.

4. The method according to claim 1, wherein the first material of the first layer (20) is a first polymer component containing silicon or silicon and a metal and the second material of the second layer (30) is a second polymer component.

5. The method according to claim 1, wherein the first material of the first layer (20) is a first polymer component containing a metal or a metal oxide and the second material of the second layer (30) is a second polymer component.

6. The method according to claim 5, wherein providing the multilayer stack (100) comprises:

   - depositing a self-organizing di-block copolymer consisting of the first polymer component and the second polymer component,
   - phase separating the self-organizing di-block copolymer, and;
   - infusing the first polymer component with a metal or a metal oxide.

7. The method according to claim 1, wherein the method further comprises:

   - patterning the multi-layer stack (100) by etching through the at least one opening (50) in the EUV photoresist layer (40),
   - removing the EUV photoresist layer, and;
   - patterning the substrate (10) using the patterned multilayer stack (105) as a hard mask.

8. An intermediate structure (800), the intermediate structure comprising:

   - a substrate (10) having an upper main surface (5),
   - a multi-layer stack (100) on the main upper surface (5), consisting of a first layer (20) of a first material and a second layer (30) of a second material, wherein the materials have different refractive indexes, and the layers are stacked alternately and repeatedly on one another, wherein the intermediate structure (800) further comprises an EUV photoresist layer (40) and the multi-layer stack (100) is sandwiched between the EUV photoresist layer and the upper main surface of the substrate,
   **characterized in that**;
   the multi-layer stack (100) is a self-organized di-block copolymer.

9. The intermediate structure according to claim 8, wherein;

   - the refractive index of the first material is higher than that of the second material, and
   - the first layer of the first material of the multi-layer stack is in direct contact with the EUV photoresist layer and wherein the first layer (20) and the second layer (30) have refractive indexes in the range of 0.85 and 1.05 at 13.5 nm wavelength.

10. The intermediate structure according to claim 9, wherein the difference in the refractive index of the first layer (20) and the second layer (30) is between 1 % and 15 %.


**Patentansprüche**

1. Verfahren zur Durchführung eines extrem ultravioletten (EUV) Photolithographie-Prozesses, wobei das Verfahren umfasst:

   - Erhalten eines zu strukturierenden Substrats (10), das eine obere Hauptoberfläche (5) aufweist,
   - Bereitstellen einer EUV-Photoresistschicht (40) auf der oberen Hauptoberfläche (5), und;
   - Ausbilden mindestens einer Öffnung (50) in der EUV-Photoresistschicht (40), wobei das Verfahren weiter ein Bereitstellen eines zwischen der EUV-Photoresistschicht (40) und der oberen Hauptoberfläche (5) angeordneten Mehrschichtstapels (100) umfasst, der eine obere Oberfläche aufweist und aus einer ersten Schicht (20) aus einem ersten Material und einer zweiten Schicht (30) aus einem zweiten Material besteht, wobei die Materialien einen unterschiedlichen Brechungsindizes aufweisen und die Schichten abwechselnd und wiederholt übereinander gestapelt sind, und wobei die mindestens eine Öffnung (50) einen Teil (7) der oberen Hauptoberfläche des Mehrschichtstapels demaskiert,

**dadurch gekennzeichnet, dass**;
der Mehrschichtstapel (100) ein selbstorganisiertes Di-Block-Copolymer ist.

2. Verfahren nach Anspruch 1, wobei

- der Brechungsindex des ersten Materials höher ist als der des zweiten Materials, und
- die erste Schicht (20) des ersten Materials des Mehrschichtstapels in direktem Kontakt mit der EUV-Photoresistschicht (40) steht, und wobei der EUV-Photolithografie-Prozess bei einer Wellenlänge im Bereich von 6 nm bis 27 nm durchgeführt wird.

3. Verfahren nach Anspruch 2, wobei der Unterschied zwischen dem Brechungsindex der ersten Schicht (20) und dem der zweiten Schicht (30) zwischen 1 % und 15 % liegt.

4. Verfahren nach Anspruch 1, wobei das erste Material der ersten Schicht (20) eine erste Polymerkomponente ist, die Silizium oder Silizium und ein Metall enthält, und das zweite Material der zweiten Schicht (30) eine zweite Polymerkomponente ist.

5. Verfahren nach Anspruch 1, wobei das erste Material der ersten Schicht (20) eine erste Polymerkomponente ist, die ein Metall oder ein Metalloxid enthält, und das zweite Material der zweiten Schicht (30) eine zweite Polymerkomponente ist.

6. Verfahren nach Anspruch 5, wobei das Bereitstellen des Mehrschichtstapels (100) umfasst:

- Ablagern eines selbstorganisierenden Di-Block-Copolymers, das aus der ersten Polymerkomponente und der zweiten Polymerkomponente besteht,
- Phasentrennung des selbstorganisierenden Di-Block-Copolymers, und;
- Infusion der ersten Polymerkomponente mit einem Metall oder einem Metalloxid.

7. Verfahren nach Anspruch 1, wobei das Verfahren weiter umfasst:

- Strukturieren des Mehrschichtstapels (100) durch Ätzen durch die mindestens eine Öffnung (50) in der EUV-Photoresistschicht (40),
- Entfernen der EUV-Photoresistschicht und;
- Strukturieren des Substrats (10) unter Verwendung des strukturierten Mehrschichtstapels (105) als Hartmaske.

8. Zwischenstruktur (800), wobei die Zwischenstruktur umfasst:

- ein Substrat (10), das eine oberen Hauptoberfläche (5) aufweist,
- einen Mehrschichtstapel (100) auf der oberen Hauptoberfläche (5), bestehend aus einer ersten Schicht (20) aus einem ersten Material und einer zweiten Schicht (30) aus einem zweiten Material, wobei die Materialien unterschiedliche Brechungsindizes aufweisen und die Schichten abwechselnd und wiederholt aufeinander gestapelt sind, wobei die Zwischenstruktur (800) weiter eine EUV-Photoresistschicht (40) umfasst und der Mehrschichtstapel (100) zwischen der EUV-Photoresistschicht und der oberen Hauptoberfläche des Substrats angeordnet ist,

**dadurch gekennzeichnet, dass**;
der Mehrschichtstapel (100) ein selbstorganisiertes Di-Block-Copolymer ist.

9. Zwischenstruktur nach Anspruch 8, wobei;

- der Brechungsindex des ersten Materials höher ist als der des zweiten Materials, und
- die erste Schicht des ersten Materials des Mehrschichtstapels in direktem Kontakt mit der EUV-Photoresistschicht steht, und wobei die erste Schicht (20) und die zweite Schicht (30) Brechungsindizes im Bereich von 0,85 und 1,05 bei einer Wellenlänge von 13,5 nm aufweisen.

10. Zwischenstruktur nach Anspruch 9, wobei der Unterschied zwischen dem Brechungsindex der ersten Schicht (20) und dem der zweiten Schicht (30) zwischen 1 % und 15 % liegt.

**Revendications**

1. Procédé de réalisation d'un traitement photolithographique par ultraviolets extrêmes (EUV), le procédé comprenant :

    - une obtention d'un substrat (10) devant subir une formation de motifs présentant une surface principale supérieure (5),
    - une fourniture d'une couche de résine photosensible EUV (40) sur la surface principale supérieure (5), et ;
    - une formation d'au moins une ouverture (50) dans la couche de résine photosensible EUV (40), dans lequel le procédé comprend en outre, une fourniture, située entre la couche de résine photosensible EUV (40) et la surface principale supérieure (5), d'un empilement multicouche (100) présentant une surface supérieure et consistant en une première couche (20) d'un premier matériau et une seconde couche (30) d'un second matériau, dans lequel les matériaux présentent un indices de réfraction différents, et les couches sont empilées en alternance et de manière répétée l'une sur l'autre, et dans lequel la au moins une ouverture (50) fait apparaître une partie (7) de la surface principale supérieure de l'empilement multicouche,

    **caractérisé en ce que** ;
    l'empilement multicouche (100) est un copolymère dibloc auto-organisé.

2. Procédé selon la revendication 1, dans lequel

    - l'indice de réfraction du premier matériau est plus élevé que celui du second matériau, et
    - la première couche (20) du premier matériau de l'empilement multicouche est en contact direct avec la couche de résine photosensible EUV (40) et dans lequel le traitement photolithographique par EUV est effectué à une longueur d'onde dans la plage de 6 nm à 27 nm.

3. Procédé selon la revendication 2, dans lequel la différence d'indice de réfraction de la première couche (20) et de la seconde couche (30) est entre 1 % et 15 %.

4. Procédé selon la revendication 1, dans lequel le premier matériau de la première couche (20) est un premier constituant polymère contenant du silicium ou du silicium et un métal et le second matériau de la seconde couche (30) est un second constituant polymère.

5. Procédé selon la revendication 1, dans lequel le premier matériau de la première couche (20) est un premier constituant polymère contenant un métal ou un oxyde métallique et le second matériau de la seconde couche (30) est un second constituant polymère.

6. Procédé selon la revendication 5, dans lequel une fourniture de l'empilement multicouche (100) comprend :

    - un dépôt d'un copolymère dibloc à auto-organisation consistant en le premier constituant polymère et le second constituant polymère,
    - une séparation de phases du copolymère dibloc à auto-organisation, et ;
    - une infusion du premier constituant polymère avec un métal ou un oxyde métallique.

7. Procédé selon la revendication 1, dans lequel le procédé comprend en outre :

    - une formation de motifs sur l'empilement multicouche (100) par gravure à travers la au moins une ouverture (50) dans la couche de résine photosensible EUV (40),
    - un retrait de la couche de résine photosensible EUV, et;
    - une formation de motifs sur le substrat (10) en utilisant l'empilement multicouche à motifs (105) comme masque dur.

8. Structure intermédiaire (800), la structure intermédiaire comprenant :

   - un substrat (10) présentant une surface principale supérieure (5),
   - un empilement multicouche (100) sur la surface principale supérieure (5), consistant en une première couche (20) d'un premier matériau et une seconde couche (30) d'un second matériau, dans laquelle les matériaux présentent des indices de réfraction différents, et les couches sont empilées en alternance et de manière répétée l'une sur l'autre, dans laquelle la structure intermédiaire (800) comprend en outre une couche de résine photosensible EUV (40) et l'empilement multicouche (100) est situé entre la couche de résine photosensible EUV et la surface principale supérieure du substrat,

   **caractérisée en ce que** ;
   l'empilement multicouche (100) est un copolymère dibloc auto-organisé.

9. Structure intermédiaire selon la revendication 8, dans laquelle ;

   - l'indice de réfraction du premier matériau est plus élevé que celui du second matériau, et
   - la première couche du premier matériau de l'empilement multicouche est en contact direct avec la couche de résine photosensible EUV et dans laquelle la première couche (20) et la seconde couche (30) présentent des indices de réfraction dans la plage de 0,85 et 1,05 à une longueur d'onde de 13,5 nm.

10. Structure intermédiaire selon la revendication 9, dans laquelle la différence d'indice de réfraction de la première couche (20) et de la seconde couche (30) est entre 1 % et 15%.

600

25

Obtaining a substrate to
be patterned

150

Providing a multi-layer
stack

200

providing an EUV
photoresist layer

300

forming at least one opening
in the photoresist layer

Fig. 1

Fig. 2a

Fig. 2b

Fig. 2c

Fig. 3 PRIOR ART

(Reference Example)

Fig. 4

Fig. 5a

Fig. 5b

Fig. 6

Fig. 7a

Fig. 7b

Fig. 7c

Fig. 7d

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040214113 A1

- US 20090269678 A1

**Non-patent literature cited in the description**

- **H. XU.** *Proceedings of SPIE,* 2009, vol. 7273
- **J.S. KIM.** *J. Vac. Sci. Technol. B,* 2015, vol. 33, 6

- **H. XU.** *Proc. Of SPIE,* 2009, vol. 7273